Europäisches Patentamt

European Patent Office

Office européen des brevets

(11) Publication number : **0 501 766 A1**

# EUROPEAN PATENT APPLICATION

(21) Application number : 92301598.6

(22) Date of filing : 26.02.92

(51) Int. Cl.⁵ : **C04B 35/00, H01L 39/24**

(30) Priority : 26.02.91 JP 30510/91

(43) Date of publication of application :
02.09.92 Bulletin 92/36

(84) Designated Contracting States :
**DE FR GB**

(71) Applicant : **SHARP KABUSHIKI KAISHA**
**22-22 Nagaike-cho Abeno-ku**
**Osaka 545 (JP)**

(72) Inventor : **Taniguchi, Hiroshi**
**2-506, Nara high town**
**606-76, Sanjo-cho, Nara-shi, Nara (JP)**
Inventor : **Koba, Masayoshi**
**1-51-14-5, Shichijonishi-machi**
**Nara-shi, Nara (JP)**

(74) Representative : **Brown, Kenneth Richard et al**
**R.G.C. Jenkins & Co. 26 Caxton Street**
**London SW1H 0RJ (GB)**

(54) **Oxide superconductor material.**

(57) In an oxide superconductor material, a part of constituent calcium element of an oxide superconductor having calcium as a constituent element such as Bi-Sr-Ca-Cu-O or Tl-Ba-Ca-Cu-O system is replaced with yttrium element so that the lattice constant makes matching with a substrate or the like on which the material is grown. Further, in a superconductor film with use of such an oxide superconductor material, a prescribed amount of yttrium atoms are substituted at the interface with a substrate or an insulator film on which the film is grown, and the substitution amount of yttrium element is decreased continuously or stepwise according to the distance from the interface.

Fig. 3

EP 0 501 766 A1

## BACKGROUND OF THE INVENTION

Field of the Invention

The present invention relates to an oxide superconductor material.

Description of the Prior Art

After the discovery of high temperature oxide superconductor materials, the research and development of these materials have been conducted in many places.

Among such high temperature superconductor materials, following materials have a critical temperature $T_c$ higher than the boiling temperature of liquid nitrogen. The critical temperature is as high as 100 K or more in some materials including calcium as a constituent element: Bi-Sr-Ca-Cu-O system ( such as $Bi_2Sr_2Ca_1Cu_2O_8$ and $Bi_2Sr_2Ca_2Cu_3O_{10}$), Tl-Ba-Ca-Cu-O system ( such as $Tl_2Ba_2Ca_1Cu_2O_8$, $Tl_2Ba_2Ca_2Cu_3O_{10}$, $Tl_1Ba_2Ca_1Cu_2O_7$, $Tl_1Ba_2Ca_2Cu_3O_9$, $Tl_1Ba_2Ca_3Cu_4O_{11}$ and $Tl_1Ba_2Ca_4Cu_5O_{13}$). Therefore, these materials are expected widely to be applied to electronic devices such as a switching element and a sensor element or to be used as new electronics materials for the metallization of an integrated circuit or the like.

However, because these oxides have layered Perovskite crystal structure, the superconducting properties of these materials have remarkable anisotropy. For example, the magnitude of critical field ($H_c$) in the magnetic field applied in parallel to the c-axis direction of such an oxide superconductor is ten to twenty times as large as the magnitude in the magnetic field applied perpendicularly to the c-axis direction. The critical current density ($I_c$) in the magnetic field applied in parallel to the c-axis direction is one hundred times as large as that in the magnetic field applied perpendicularly to the c-axis direction. Therefore, it is needed to improve the crystalline orientation of such an oxide superconductor for applications in a field of power electronics or in a field of microelectronics to be used at a high current density.

In order to solve the problems due to anisotropy of such an oxide superconductor, for example, an oxide superconductor film is oriented along the c-axis direction by selecting a substrate material or a crystal plane. The c-axis is a direction of crystal growth on a substrate. Then, a $SrTiO_3$ (100) substrate is said to be best for preparing a film of these oxide superconductors because it is stable chemically and has about the same lattice constant as that of such an oxide. However, strictly speaking, even a $SrTiO_3$ (100) substrate has about two per cent of mismatching of lattice constant. Thus, an oxide film superconductor grown on the substrate cannot be oriented perfectly along the c-axis direction or the crystalline property of a film is not sufficient. That is, the characteristics of oxide superconductors cannot be exploited fully.

## SUMMARY OF THE INVENTION

An object of the present invention is to provide a new oxide superconductor which can solve the above-mentioned problems of orientation and crystalline property due to anisotropy.

In an oxide superconductor material of the present invention, a part of constituent calcium element of an oxide superconductor having calcium as a constituent element such as Bi-Sr-Ca-Cu-O or Tl-Ba-Ca-Cu-O system is replaced with yttrium element.

In a superconductor film with use of such an oxide superconductor material, a prescribed amount of yttrium atoms are substituted at the interface with a substrate or an insulator film on which the film is grown, and the substitution amount of yttrium element is decreased continuously or stepwise according to the distance from the interface.

An advantage of the present invention is that the worsening of superconducting properties due to the mismatching of lattice constant with a substrate or the like can be prevented.

## BRIEF DESCRIPTION OF THE DRAWINGS

These and other objects and features of the present invention will become clear from the following description taken in conjunction with the preferred embodiments thereof with reference to the accompanying drawings, and in which:

Fig. 1 is a diagram of crystal structures of Bi-and Tl-system-based oxide superconductors;

Fig. 2 is a diagram which shows a change of lattice constant due to the substitution of constituent element of Bi-system-based oxide superconductor; and

Fig. 3 is a graph of the temperature dependence of electrical resistance of oxide superconductors of various amounts of substitution.

## DETAILED DESCRIPTION OF THE PREFERRED EMBODIMENTS

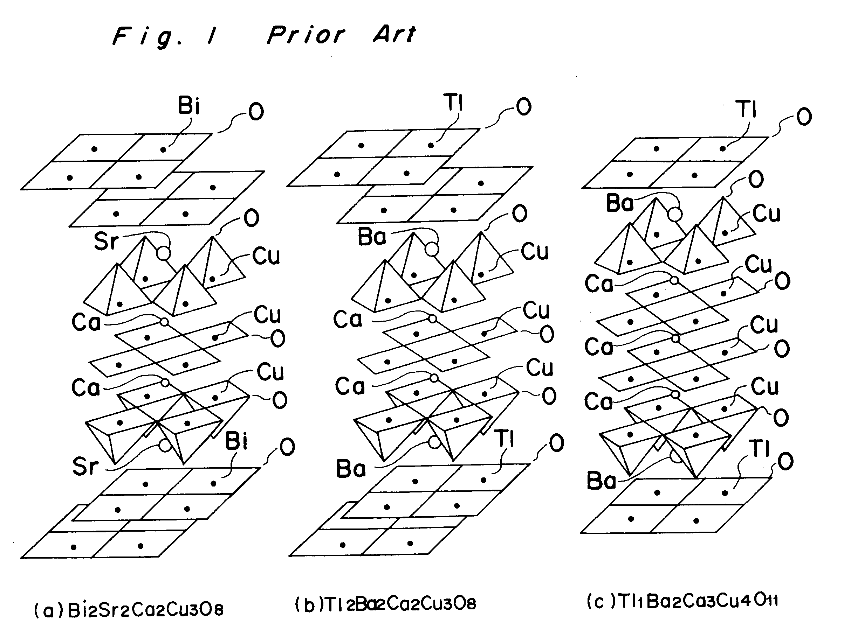

The above-mentioned prior art Bi-Sr-Ca-Cu-O and Tl-Ba-Ca-Cu-O systems have rhombohedral and tetragonal crystal structures of layered Perovskite type at room temperature, as shown in Fig. 1.

A common characteristic of the crystal structures shown in Fig. 1 is that oxygen atoms are coordinated around a copper atom like a pyramid or like an octahedron. In these crystal structures, Cooper pairs of holes which contribute the superconducting current are thought to flow along $CuO_2$ planes.

In an experiment for controlling the hole concentration of superconducting carriers by substituting a part of constituent elements with another element, the inventors found that the lattice constant of Bi- and Tl-system-based oxide superconductors can be changed. That is, when a part of divalent Ca sites is replaced with trivalent yttrium ions in Bi- and Tl-system-based oxide superconductors including calcium as a constituent element, such as Bi-Sr-Ca-Cu-O and Tl-Ba-Ca-Cu-O systems, a new type of oxide superconductor materials such as Bi-Sr-Ca-Y-Cu-O and Tl-Ba-Ca-Y-Cu-O systems can be obtained. In these oxide superconductors, the lattice constants can be changed according to the substitution amount of yttrium, without deteriorating the superconducting properties largely.

Therefore, it is possible to deposit an oxide superconductor film on a substrate having a lattice constant different from that of the oxide by matching the lattice constant.

Further, in a superconductor film with use of such an oxide superconductor material, a prescribed amount of yttrium atoms, which is determined so as to match with the lattice constant of a substrate or an insulator film on which the film is grown, are substituted at the interface with the substrate or the insulator film, and the substitution amount of yttrium element is decreased continuously or stepwise according to the distance from the interface. Thus, it becomes possible to change the substitution amount of yttrium stepwise or continuously or to change the composition, so as to reach smoothly the composition of the best quality of a Bi-Sr-Ca-Cu-O, Tl-Ba-Ca-Cu-O system or the like.

In an embodiment, three kinds of samples A, B and C of Bi-Sr-Ca-Y-Cu-O system of different compositions from each other are prepared with a solid state reaction process by using powders of high purity of $Bi_2O_3$, $Sr_2O_3$, $CaCo_3$, $Y_2O_3$ and $CuO$. The composition ratio $Bi:Sr:Ca:Y:Cu$ are 2:2:1:0:2 for sample A, 2:2:0.8:0.2:2 for sample B and 2:2:0.6:0.4:2 for sample C when the powders are weighed.

Each sample is synthesized with an ordinary solid state reaction process. Then, it is sintered in air for 110 hours at 850 °C and then it is heated in air for 15 hours at 500 °C for controlling the oxygen ratio.

The three samples are subjected to measurements mentioned below.

First, a ratio of yttrium atoms to the sum of calcium and yttrium atoms ($Y/(Ca+Y)$) is measured for each sample with an X-ray microanalysis technique. It is confirmed that the ratio is 0 % for sample A, 18% for sample B and 36% for sample C.

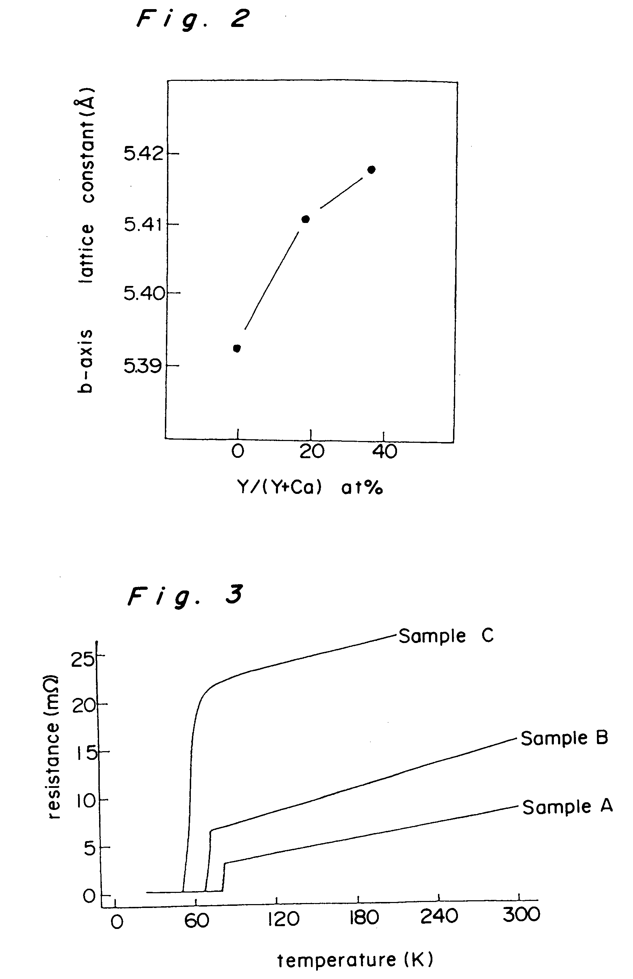

Next, the temperature dependence of electrical resistance is measured for each sample, and Fig. 3 shows the results. It is confirmed that the samples A, B and C have zero resistance and transform to the superconducting state at 79 K, at 66 K and at 48 K, respectively.

X-ray diffraction patterns ($CuK\alpha$) are measured for each sample, and it is confirmed that the samples all have a rhombohedral crystal structure which is the same as that of Bi-system-based oxide superconductors.

Fig. 2 shows the relation of the b-axis lattice constant (Å) obtained from the X-ray diffraction patterns against the ratio $Y/(Y+Ca)$. The b-axis lattice constant increases with increasing substitution amount of a constituent element, calcium, to yttrium in a Bi-system-based superconductor. Therefore, once a diagram of lattice constant in correspondence to the substitution amount of yttrium is prepared, it becomes possible to deposit a superconductor film of lattice constant by making the lattice constant to be matched with that of a substrate to be used.

By depositing an oxide superconductor film, on the film deposited as mentioned above on the substrate or the like, so as to change stepwise or continuously the substitution amount of yttrium having lattice constants different from those of the oxide of the former film, it becomes possible to prepare a superconductor film by matching the lattice constants between them.

Although the present invention has been fully described in connection with the preferred embodiments thereof with reference to the accompanying drawings, it is to be noted that various changes and modifications are apparent to those skilled in the art. Further, a technique for manufacturing a film such as sputtering, vacuum deposition or chemical vapor deposition can also be used. Such changes and modifications are to be understood as included within the scope of the present invention as defined by the appended claims unless they depart therefrom.

## Claims

1. An oxide superconductor material of a Bi-Sr-Ca-Cu-O system, wherein a part of calcium atoms are replaced with yttrium atoms.

2. An oxide superconductor material according to Claim 1, wherein the Bi-Sr-Ca-Cu-O system has a composition of $Bi_2Sr_2(Ca_{1-x}Y_x)_1Cu_2O_8$.

3. An oxide superconductor material, comprising a material of a Tl-Ba-Ca-Cu-O system, wherein a part of calcium atoms are replaced with yttrium atoms.

4. An oxide superconducting material according to Claim 1, wherein the oxide superconducting material is applied to a substrate and the substitution amount of calcium is determined so that the lattice constant of the material matches with that of the substrate.

5. An oxide superconductor material, comprising a first film of oxide superconducting material of a Bi-Sr-Ca-Cu-O system applied to a substrate, wherein a part of calcium is substituted with yttrium and the substitution amount of calcium is determined so that the lattice constant matches with that of the substrate; and

a second superconductor material film applied to the first film, which second film having a substitution amount of calcium different from that of the first film.

6. An oxide film according to Claim 5, wherein the substitution amount of calcium in the second film is changed continuously or stepwise according to the distance from the interface to a composition in correspondence with the best superconductor properties.

7. A ceramic oxide superconductor material in which calcium is a constituent element, wherein a proportion of the calcium atoms are replaced with yttrium atoms.

8. A Bi- or Tl-based ceramic oxide superconductor material in which calcium is a constituent element, wherein a proportion of the calcium atoms are replaced with yttrium atoms.

Fig. 1 Prior Art

(a) Bi2Sr2Ca2Cu3O8

(b) Tl2Ba2Ca2Cu3O8

(c) Tl1Ba2Ca3Cu4O11

# Fig. 2

# Fig. 3

**European Patent Office**

**EUROPEAN SEARCH REPORT**

Application Number

EP 92 30 1598

## DOCUMENTS CONSIDERED TO BE RELEVANT

Page 1

| Category | Citation of document with indication, where appropriate, of relevant passages | Relevant to claim | CLASSIFICATION OF THE APPLICATION (Int. Cl.5 ) |
|---|---|---|---|
| X | PHYSICA C. vol. 157, no. 3, 1 March 1989, AMSTERDAM NL pages 531 - 536; S. OLIVIER ET AL.: 'ON THE SOLID SOLUTIONS IN THE SYSTEMS B12Sr2Ca(1-x)YxCu2O8, B12Sr(2-x)LaxYCu2O8 AND B12Sr2Y(1-x)CeCu2O8' | 1,2,7,8 | C04B35/00 H01L39/24 |
| Y | * the whole document * | 4-6 | |
| X | MATERIALS SCIENCE & ENGINEERING B2 vol. 1989, no. 4, April 1989, LAUSANNE, CH pages 277 - 280; B. CHEVALIER ET AL.: 'SUPERCONDUCTING PROPERTIES OF SUBSTITUTED OXIDES B12Sr2(Ca(1-x)Yx)Cu2O8+' | 1,2,7,8 | |
| Y | * the whole document * | 4-6 | |
| X | APPLIED PHYSICS LETTERS. vol. 54, no. 16, 17 April 1989, NEW YORK US pages 1591 - 1593; J.L. TALLON ET AL.: 'ENHANCING Tc IN B12.1CaSr2Cu2O8+' | 1,7,8 | |
| Y | * the whole document * | 4-6 | TECHNICAL FIELDS SEARCHED (Int. Cl.5 ) |
| X | MOLECULAR CRYSTALS AND LIQUID CRYSTALS. vol. 184, November 1990, MONTREUX CH pages 141 - 145; T. MANAKO ET AL.: 'SYNTHESIS AND PHYSICAL PROPERTIES OF T1-O MONOLAYER SUPERCONDUCTORS: T1Ba(1+x)La(1-x)CuO5 AND T1Ba2Y(1-x)CaxCu2O7' | 3,7,8 | C04B H01L |
| Y | * the whole document * | 4-6 | |
| X | PHYSICA C. vol. 168, no. 1/2, 1 June 1990, AMSTERDAM NL pages 8 - 22; C. MARTIN ET AL.: 'THALLIUM CUPRATES: THE CRITICAL TEMPERATURE IS MAINLY GOVERNED BY THE OXYGEN NONSTOCHIOMETRY' | 3,7,8 | |
| Y | * page 8 * | 4-6 | |
| | -/-- | | |

The present search report has been drawn up for all claims

| Place of search | Date of completion of the search | Examiner |
|---|---|---|
| THE HAGUE | 11 JUNE 1992 | LUETHE H. |

EPO FORM 1503 03.82 (P0401)

European Patent
Office

**EUROPEAN SEARCH REPORT**

Application Number

EP 92 30 1598
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 337 699 (KABUSHIKI KAISHA TOSHIBA) 18 October 1989 <br> * the whole document * | 4-6 | |
| | ----- | | |
| | | | **TECHNICAL FIELDS SEARCHED (Int. Cl.5 )** |

The present search report has been drawn up for all claims

| Place of search | Date of completion of the search | Examiner |
|---|---|---|
| THE HAGUE | 11 JUNE 1992 | LUETHE H. |

CATEGORY OF CITED DOCUMENTS

X : particularly relevant if taken alone
Y : particularly relevant if combined with another
　document of the same category
A : technological background
O : non-written disclosure
P : intermediate document

T : theory or principle underlying the invention
E : earlier patent document, but published on, or
　after the filing date
D : document cited in the application
L : document cited for other reasons

& : member of the same patent family, corresponding
　document

EPO FORM 1503 03.82 (P0401)